(19) **Europäisches Patentamt / European Patent Office / Office européen des brevets**

(11) **EP 4 600 311 A1**

(12) **EUROPEAN PATENT APPLICATION**
published in accordance with Art. 153(4) EPC

(43) Date of publication:
**13.08.2025 Bulletin 2025/33**

(21) Application number: **23874788.5**

(22) Date of filing: **29.09.2023**

(51) International Patent Classification (IPC):
*C08L 83/07* (2006.01)     *B32B 27/00* (2006.01)
*C08J 5/18* (2006.01)       *C08K 3/013* (2018.01)
*C08L 83/05* (2006.01)     *H04R 19/02* (2006.01)
*H10N 30/857* (2023.01)

(52) Cooperative Patent Classification (CPC):
B32B 27/00; C08J 5/18; C08K 3/013; C08L 83/04;
H04R 19/02; H10N 30/857

(86) International application number:
**PCT/JP2023/035780**

(87) International publication number:
**WO 2024/075661 (11.04.2024 Gazette 2024/15)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **05.10.2022 JP 2022160896**

(71) Applicant: **Dow Toray Co., Ltd.**
**Tokyo 140-8617 (JP)**

(72) Inventors:
- **FUKUI, Hiroshi**
  **Ichihara-shi Chiba 299-0108 (JP)**
- **SHIMA, Ryoto**
  **Ichihara-shi Chiba 299-0108 (JP)**

(74) Representative: **Murgitroyd & Company**
**165-169 Scotland Street**
**Glasgow G5 8PL (GB)**

(54) **CURABLE ORGANOPOLYSILOXANE COMPOSITION FOR TRANSDUCERS, CURED PRODUCT OF SAME, AND TRANSDUCER AND OTHERS EACH PROVIDED WITH SAID CURED PRODUCT**

(57)     [Problem] To provide a curable organopolysiloxane composition that yields a organopolysiloxane cured product having viscoelastic properties (particularly, reversion characteristics after deformation due to external stress) that are particularly suitable for use as a dielectric layer or a transducer, and a method of use thereof. [Resolution Means] A curable organopolysiloxane composition for transducers, containing, (a) a chain organopolysiloxane or mixture thereof having a weight-average molecular weight (Mw(a)) of less than $8.0 \times 10^4$, and (b1) a crosslinking agent, (b2) a chain length extender, and (c) a hydrosilylation reaction catalyst, wherein the molar quantity of Si-H ($H_{b1}$, $H_{b2}$) in component (b1) and component (b2) and the molar quantity of curable reactive groups (Vi) in component (a), satisfy the following relationship: $p_{x1} = \{H_{b1}/H_{b2}\}/\{(H_{b1}+H_{b2})/Vi\}$ and wherein the obtained by dividing Mw(a) by the value of $p_{x1}$ ($=Mw(a)/p_{x1}$) is in a range of 1,000 to 8,000.

EP 4 600 311 A1

## Description

## TECHNICAL FIELD

The present invention relates to a curable organopolysiloxane composition for transducers, and in particular, is characterized in that it yields a organopolysiloxane cured product having a low storage modulus over a broad frequency range, has low loss tangent properties, and has viscoelastic properties that are particularly suitable as a dielectric layer for transducers.

Furthermore, the present invention relates to, inter alia, use of the organopolysiloxane cured product as a transducer component, electronic material, or display device component.

## BACKGROUND ART

Electroactive silicone materials have mechanical properties and/or electric properties, specifically, a high specific dielectric constant, high dielectric breakdown strength, and a low Young's modulus, allowing for a high energy density to be achieved, and also have excellent mechanical strength (specifically, tensile strength, tear strength, elongation percentage, and the like) when used as a dielectric layer in a transducer, and thus durability and a practical displacement amount can be realized, and the electroactive silicone materials can be suitably used as transducer materials.

For example, the present applicants disclose that a fluoroalkyl group-containing organopolysiloxane cured product has a high specific dielectric constant and is useful as a transducer material (Patent Document 1 or 2).

Furthermore, the present applicants have disclosed a curable organopolysiloxane composition suitable as a material for transducers due to having excellent coating properties and mechanical strength (Patent Document 3).

In addition, based on the relationship between vinyl curable functional groups in a main component, crosslinkable SiH polysiloxanes, and chain length extended SiH polysiloxanes, the present applicants have proposed that when a parameter (defined as $p_{x1}$) relating to crosslink density in the organopolysiloxane composition is in a range of 0.1 to 6.0, a curable organopolysiloxane composition for transducers containing an adhesion-imparting agent or the like yields an organopolysiloxane cured product having excellent adhesive strength and followability (Patent Document 4).

However, in recent years, there has been a strong demand in the field of transducer materials, such as actuators, for electroactive silicone materials to have improved favorable reversion characteristics after deformation by external stresses, such as those from sensors, or the like, and there is no specific disclosure of a curable organopolysiloxane composition for transducers that yields an organopolysiloxane cured product having favorable reversion characteristics after deformation (specifically, a low storage modulus in a broad frequency range, and a low loss tangent), even in Patent Document 4.

## RELATED ART DOCUMENTS

### Patent Documents

Patent Document 1: WO 2014/105959
Patent Document 2: WO 2015/098072
Patent Document 3: WO 2020/116440
Patent Document 4: WO PCT/JP2022/026764 (unpublished at the time of filing)

## SUMMARY OF THE INVENTION

### PROBLEM TO BE SOLVED BY THE INVENTION

In light of the foregoing, an object of the present invention is to provide a curable organopolysiloxane composition that yields a organopolysiloxane cured product having low storage modulus over a broad frequency range, and a low loss tangent, and therefore has favorable reversion characteristics after deformation by pressing of a sensor, or the like, and viscoelastic properties particularly suitable for use as a dielectric layer for transducers.

Similarly, an object of the present invention is to provide an application of the curable organopolysiloxane composition as a transducer material such as a sensor or the like.

## MEANS FOR SOLVING THE PROBLEM

As a result of extensive investigations, the inventors of the present invention have discovered that the object above can be yielded by a curable organopolysiloxane composition for transducers of the present invention made by selectively using straight chain organopolysiloxanes or mixtures thereof having a weight-average molecular weight Mw(a) of less than $8.0 \times 10^4$, and having a value obtained by dividing Mw(a) by the value of $p_{x1}$, which is a parameter related to the crosslink density in the organopolysiloxane composition (that is, the value given by "Mw(a)/$p_{x1}$"), in a range of 1,000 to 8,000, and preferably having a SiH/Vi ratio of less than 1 (specifically, in a range of 0.1 to 0.99).

More specifically, the problem can be solved by curable organopolysiloxane composition for transducers, provided with

(a) a straight chain or branched chain organopolysiloxane or a mixture thereof, having a weight-average molecular weight Mw(a) of the entire component of less than $8.0 \times 10^4$ and having a curing reactive group containing at least two carbon-carbon double bonds in the molecule,

(b1) an organohydrogenpolysiloxane having at least one silicon-bonded hydrogen atom at a side chain site of the molecular chain, having no silicon-bonded hydrogen atoms at least one terminus of the molecular chain, and having at least two silicon-bonded hydrogen atoms in the molecule,

(b2) an organohydrogenpolysiloxane having a silicon-bonded hydrogen atom at both termini of the molecular chain and having at least two silicon-bonded hydrogen atoms in the molecule, and

(c) an effective amount of a hydrosilylation reaction catalyst, wherein

the molar quantity of silicon-bonded hydrogen atoms in component (b1) (Hb1),

the molar quantity of silicon-bonded hydrogen atoms in component (b2) (Hb2),

and the molar quantity of curable reactive groups containing carbon-carbon double bonds in component (a) (Vi) in the present composition are expressed by the following relationship:

$$p_{x1}=\{H_{b1}/H_{b2}\}/\{(H_{b1}+H_{b2})/Vi\}$$

the value obtained by dividing Mw(a) by the value of $p_{x1}$ defined as above is in a range of 1,000 to 8,000.

Here, it is preferable that the sum of the molar quantities of silicon-bonded hydrogen atoms of component (b1) and component (b2) be in a range of 0.1 to 0.99 mol per mol of carbon-carbon double bonds in component (a), and it is preferable that component (a) is a straight chain or branched chain organopolysiloxane or a mixture thereof, having a curing-reactive group containing a carbon-carbon double bond at both termini of the molecular chain. In addition, the composition may further contain (d) a reinforcing filler and/or (e) an adhesion promoting agent. Furthermore, it is preferable that the overall viscosity of the composition be in a range of 100 to 2,000 Pa·s when measured at a shear rate of 0.1 (s$^{-1}$) using a viscoelasticity measurement device at 25°C.

The value of the storage modulus (G') at 23°C of the organopolysiloxane cured product obtained by curing the composition is preferably in a range of $5.00 \times 10^3$ to $1.00 \times 10^5$ Pa at the measurement frequencies of 0.1 Hz and 1 Hz, and the loss tangent at these measurement frequencies is less than 0.3. The loss tangent (tan δ) is the value obtained by dividing the loss modulus (G") by the storage modulus (G') at the measurement frequency (=G"/G').

Furthermore, the above problems are preferably solved by using an organopolysiloxane cured product made by curing or semi-curing the above composition, and use thereof as a dielectric layer for transducers, a transducer having a structure in which at least one or more layers of organopolysiloxane cured products are interposed between at least one pair of electrode layers, and a manufacturing method thereof.

## EFFECT OF THE INVENTION

The present invention provides a curable organopolysiloxane composition that yields a organopolysiloxane cured product having excellent electrical properties, a low storage modulus over a broad frequency range, and a low loss tangent, and therefore favorable reversion characteristics after deformation and viscoelastic properties which are particularly suitable for use as a dielectric layer for transducers. Furthermore, the present invention provides an electroactive silicone material that can be used as a member for a film-like or sheet-like transducer, especially as a dielectric layer for transducers, a transducer containing the silicone material and having favorable reversion characteristic after deformation, and methods of manufacturing thereof.

## DESCRIPTION OF THE PREFERRED EMBODIMENTS

First, the curable organopolysiloxane composition for transducers of the present invention will be described below in detail. Hereinafter, the term "transducer" as used herein refers to all electronic devices that have the ability to mutually convert mechanical and electrical energy, a concept that includes sensors, speakers, actuators, and generators. The curable organopolysiloxane composition of the present invention provides favorable properties before and after curing when a cured product, and particularly a cured product film is suitable for use as a member of the aforementioned transducer.

In the present invention, "weight-average molecular weight" refers to the weight-average molecular weight calculated based on standard polystyrene, as measured by gel permeation chromatography (GPC). Note that the meaning and calculation method of weight-average molecular weight when component (a) is a mixture are described below.

The composition according to the present invention contains

(a) a straight chain or branched chain organopolysiloxane or a mixture thereof, having a weight-average molecular weight of the entire component is less than $8.0 \times 10^4$ and having a curing reactive group containing at least two carbon-carbon double bonds in the molecule,

(b1) an organohydrogenpolysiloxane having at least one silicon-bonded hydrogen atom at a side chain site of the molecular chain, having no silicon-bonded hydrogen atoms at at least one terminus of the molecular chain, and having at least two silicon-bonded hydrogen atoms in the molecular chain,

(b2) an organohydrogenpolysiloxane having a silicon-bonded hydrogen atom at both termini of the molecular chain and having at least two silicon-bonded hydrogen atoms in the molecule, and

(c) at least an effective amount of a hydrosilylation reaction catalyst, preferably includes

(d) a reinforcing filler and/or (e) an adhesion imparting agent, and optionally may include a hydrosilylation reaction inhibitor, other organic solvents, and any other additives.

**The** composition of the present invention is a hydrosilylation reactioncured composition with an alkenyl group and silicon atom-bonded hydrogen atoms, and has the advantages of relatively rapid overall curing and easy control of the reaction. **The** curing reaction proceeds with heat, irradiation with high energy radiation, or a combination thereof.

[Weight-average molecular weight (Mw(a)) of component (a) and component (a) in the composition]

Component (a) is an essential component for achieving the technical effects of the present invention, in particular, favorable reversion characteristics after deformation, and is a linear or branched organopolysiloxane or a mixture thereof having a weight-average molecular weight (Mw(a)) of less than $8.0 \times 10^4$ and a curing reactive group containing at least two carbon-carbon double bonds in the molecule.

Component (a) is a chain organopolysiloxane or mixture thereof as described above, and the weight-average molecular weight of component (a) in the composition can be calculated by the following formula.

$$Mw = \sum_{k=1}^{n} (Mwk \times wfk) \qquad (1)$$

Mwk and wfk are the weight-average molecular weight of the organopolysiloxane constituting the kth component (a), and the weight fraction of that component in the total component (a).

The weight-average molecular weight (Mw(a)) of component (a) must be $8.0 \times 10^4$ and when the weight-average molecular weight of component (a) in the composition exceeds the upper limit, it may not be possible to yield the favorable reversion characteristics after deformation and the viscoelastic properties in the organopolysiloxane cured product, which are the object of the present invention, even when the value obtained by dividing Mw(a) by the value of $p_{x1}$, which is a parameter related to cross-link density as described later, is in a range of 1,000 to 8,000. Note that as described above, component (a) may be a mixture of the chain organopolysiloxanes, and component (a) as a whole must have a weight-average molecular weight less than the lower limit, but preferably each of the aforementioned chain organopolysiloxanes included in component (a) has a weight-average molecular weight of $8.0 \times 10^4$ or less, and particularly preferably, the composition does not contain any chain organopolysiloxane having a weight-average molecular weight of $8.0 \times 10^4$ or more.

Component (a), an organopolysiloxane, has a chain structure, and specifically is a straight chain or branched chain organopolysiloxane, preferably a straight chain or branched chain organopolysiloxane having a curing reactive group containing a carbon-carbon double bond at both termini of the molecular chain, and especially preferably a straight chain organopolysiloxane having a curing reactive group containing carbon-carbon double bonds at both termini of the molecular chain.

The curing reactive group contains a carbon-carbon double bond in the organopolysiloxane of component (a), and examples include curing reactive groups selected from alkenyl groups having 2 to 20 carbon atoms such as a vinyl group and the like; and (meth)acryl groups such as 3-acryloxypropyl groups, 3-methacryloxypropyl groups, and the like.

The organopolysiloxane of component (a) may contain a group selected from monovalent hydrocarbon groups that do not have a carbon-carbon double bond in a molecule, hydroxyl groups, and alkoxy groups having 1 to 3 carbon atoms. Furthermore, the monovalent hydrocarbon group may have some hydrogen atoms partially substituted with a halogen atom or hydroxyl group, and when used as a dielectric layer, the dielectric functional group described later may be introduced. Methyl groups, phenyl groups, hydroxyl groups, alkoxy groups, and dielectric functional groups as described later are industrially preferred. Note that when component (a) contains a hydroxyl group or the like, the component has condensation reactivity in addition to hydrosilylation reaction curability.

Here, when using component (a), the amount of curing reactive groups including carbon-carbon double bonds such as alkenyl groups (Vi) in component (a) must be selected or designed such that the value obtained by dividing Mw(a) by the value of $p_{x1}$, which is a parameter related to the cross-link density and cross-link structure of the composition, as described below, is in a range of 1,000 to 8,000.

Component (a) in the present invention is capable of and preferably does introduce a fluoroalkyl group expressed by $(C_pF_{2p+1})$-R- (where R is an alkylene group having 1 to 10 carbon atoms and p is an integer between 1 and 8, inclusively) as a dielectric functional group in the molecule. In terms of the dielectric properties, economy, ease of manufacturing, and moldability of the obtained curable organopolysiloxane composition, a group in which p = 1, in other words, a trifluoropropyl group, is preferable.

Preferably, component (a) is an organopolysiloxane containing a fluoroalkyl group where at least a partially or entirely of the fluoroalkyl groups are: (a1f) one or more fluoroalkyl groups having at least two alkenyl groups having 2 to 12 carbon atoms per molecule, wherein 10 mol% or more of all substituent groups on the silicon atoms are fluoroalkyl groups expressed by $(C_pF_{2p+1})$-R- (where R is an alkylene group having 1 to 10 carbon atoms and p is an integer between 1 and 8, inclusively). By using such component (a1f) as the base resin, it is possible to obtain a cured fluoroorganopolysiloxane film having excellent dielectric properties.

[Component (b): (b1) and (b2)]

Component (b) is an organohydrogenpolysiloxane having at least two silicon-bonded hydrogen atoms in a molecule and is a component that functions as (b1) a crosslinking agent, or (b2) a chain extender for component (a).

Specifically, component (b1) is an organohydrogenpolysiloxane having at least one silicon-bonded hydrogen atom at a side chain site of the molecular chain, having no silicon-bonded hydrogen atoms at least one terminus of the molecular chain, and having at least two silicon-bonded hydrogen atoms in the molecular chain, and is distinguished from component (b2) by not having a silicon atom-bonded hydrogen atom, and preferably has a structure in which both ends of the molecular chain are sealed with functional groups that are non-reactive to the hydrosilylation reaction (especially the reaction with component (A) described above). Such component (b1) has hydrogen atoms bonded to the silicon atoms forming the main chain of the siloxane molecule (= hydrogen atoms bonded to side chain moieties), and therefore an intermolecular crosslink structure is formed between the hydrogen atoms on the side chain and the curing reactive groups in component (a), however the chain length extension effect of the crosslinked material is limited.

Component (b2), on the other hand, is an organohydrogenpolysiloxane having a silicon-bonded hydrogen atom at both termini of the molecular chain and having at least two silicon-bonded hydrogen atoms in the molecule, but preferably has two silicon-bonded hydrogen atoms (= only on both termini of the molecular chain). Such component (b2) is a chain extender that reacts with the curing reactive groups in component (a) to introduce a long siloxane molecular structure into the cross-linked material, which can give the cross-linked material moderate flexibility and elasticity.

Examples of component (b1) include 1,1,3-3-tetramethyldisiloxane, 1,3,5,7-tetramethyl cyclotetrasiloxane, tris(dimethylhydrogensiloxy)methylsilane, tris(dimethylhydrogensiloxy)phenylsilane, methylhydrogenpolysiloxanes having both ends of the molecular chain blocked by a trimethylsiloxy group, dimethylsiloxane/methylhydrogensiloxane copolymers having both ends of the molecular chain blocked by a trimethylsiloxy group, methylhydrogensiloxane and phenylsiloxane copolymers having both ends of the molecular chain blocked by a trimethylsiloxy group, methylhydrogensiloxane, diphenyl siloxane, and dimethyl siloxane copolymers blocked at both ends of a molecular chain with a trimethylsiloxane group, methylhydrogensiloxane/dimethylsiloxane/trifluoropropylmethylsiloxane copolymers having both ends of the molecular chain blocked by a trimethylsiloxy group, methylhydrogensiloxane/diphenylsiloxane/dimethylsiloxane copolymers having both ends of the molecular chain blocked by a trimethylsiloxy group, hydrolytic condensates of trimethoxysilane, copolymers containing $(CH_3)_2HSiO_{1/2}$ units and $SiO_{4/2}$ units, copolymers containing $(CH_3)2HSiO_{1/2}$ units, $SiO_{4/2}$ units, and $(C6H_5)SiO_{3/2}$ units, and mixtures of two or more types thereof.

Examples of component (b2) include dimethylsiloxanes blocked at both ends of a molecular chain with dimethylhydrogensiloxy groups, dimethylsiloxane-diphenylsiloxane copolymers blocked at both ends of a molecular chain with dimethylhydrogensiloxy groups, dimethylsiloxane/trifluoropropylmethylsiloxane copolymers blocked at both ends of a molecular chain with dimethylhydrogensiloxy groups, dimethylsiloxane/trifluoropropylmethylsiloxane copolymers blocked at both ends of a molecular chain with dimethylhydrogensiloxy groups, and mixtures of two or more types of these.

[Parameter $p_{x1}$]

The curable organopolysiloxane composition for transducers according to the present invention has, as relating to component (a), component (b1), and component (b2), a value obtained by dividing Mw(a) by a value of $p_{x1}$, defined by the following parameter, that is within a prescribed range. $p_{xl}$ is a parameter used to describe the crosslink density of the cured product obtained from the curing of this composition and the crosslink structure between molecules, defined by the following relationship: $p_{x1}=\{H_{b1}/H_{b2}\}/\{(H_{b1}+H_{b2})$ is the number of hydrogen atoms bonded to silicon atoms in component (b1), ($H_{b2}$) is the number of hydrogen atoms bonded to silicon atoms in component (b2), (Vi) represents a total number of curing reactive groups containing a carbon-carbon double bond in component (a), and the type and amount of component (b1) and component (b2) used must be an amount such that the value obtained by dividing Mw(a) by the value of $p_{x1}$ is in a range of 1,000 to 8,000. On the other hand, when $p_{x1}$ is outside the range, favorable viscoelastic properties and the resulting favorable reversion characteristics after deformation may not be yielded in the organopolysiloxane cured product. As described above, when the weight-average molecular weight of component (a) exceeds the upper limit, the technical effect of the present invention may not be achieved even when the value obtained by dividing Mw(a) by the value of $p_{x1}$ is within the range. Note that in the present invention, the value of $p_{x1}$ is preferably in a range of 6.5 to 20.0.

The technical significance of the value yielded by dividing Mw(a) by $p_{x1}$ (in other words, the value given by "Mw(a) $p_{x1}$") is described below. The present composition contains two organohydrogenpolysiloxanes, component (a) has a weight-average molecular weight (Mw(a)) of less than $8.0 \times 10^4$, where component (b1) functions as a cross-linking agent and component (b2) functions as a chain length extender. $\{H_{b1}/H_{b2}\}$ represents the ratio of Si-H in the crosslinking agent and the chain length extender, and when this ratio is within a specific range, a crosslinked structure is formed with a moderately long intermolecular distance between the curing reactive groups in component (a), thus providing a moderate hardness and rubber-like storage modulus. Furthermore, when the value obtained by dividing Mw(a), which represents the weight-average molecular weight of component (a), divided by the value of $p_{x1}$, determined by $(H_{b1}+H_{b2})/Vi$ indicating the "SiH/Vi ratio," is within a range of 1,000 to 8,000, assuming the use of component (a) having the weight-average molecular weight, the organopolysiloxane cured product, which is a cross-linked material, will demonstrate low storage modulus across a broad frequency range, and the loss tangent will tend to be low, as a result, a film or sheet-like member made from this cured product can achieve favorable reversion characteristics after deformation that occurs by pressing on the dielectric layer for a transducer such as a sensor.

The amount of component (b1) and component (b2) used must satisfy a range, and is preferably amounts such that the sum of silicon-bonded hydrogen atoms of component (b1) and component (b2) per 1 mole of carbon-carbon double bonds in component (a) (hereinafter referred to as the "SiH/Vi ratio") is in a range of 0.1 to 10 moles, more preferably less than 1.0 mole, and specifically, in a range of 0.1 to 0.99 moles. From the viewpoint of achieving curability and favorable viscoelasticity of the curable organopolysiloxane composition of the present invention, the SiH/Vi ratio by moles is particularly preferably in a range of 0.30 to 0.90, 0.40 to 0.80, or 0.50 to 0.75 moles.

[Component (c)]

Component (c) is a catalyst that promotes a hydrosilylation reaction between component (a) and component (b), and suitable examples of such catalysts include platinum-based, rhodium-based, palladium-based, nickel-based, iridium-based, ruthenium-based, and iron-based catalysts, with platinum-based catalysts being preferred. Exemplary platinum-based catalysts include platinum fine powder, chloroplatinic acid, an alcohol solution of chloroplatinic acid, a platinum-alkenyl siloxane complex, a platinum-olefin complex, a platinum-carbonyl complex, and a catalyst in which these platinum-based catalysts are dispersed or encapsulated with a thermoplastic resin such as silicone resin, polycarbonate resin, acrylic resin, or the like, with a platinum-alkenyl siloxane complex particularly preferable. In particular, a 1,3-divinyl-1,1,3,3-tetramethyldisiloxane complex of platinum is preferred, and is preferably added in the form of an alkenylsiloxane solution of the complex. In addition, in terms of improving the handleability as well as the pot life of the composition, a platinum containing hydrosilylation reaction catalyst in microparticles dispersed and encapsulated with thermoplastic resin may be used. It should be noted that as the catalyst for promoting the hydrosilylation reaction, a non-platinum-based metal catalyst such as iron, ruthenium, iron/cobalt, or the like may be used.

Furthermore the hydrosilylation reaction catalyst, which is component (c), may be a catalyst that does not exhibit activity without irradiation by high-energy radiation but shows activity within the composition upon exposure to high-energy radiation, such as a so-called high-energy radiation-activated catalyst or a photo-activated catalyst. By using such a component (c), the composition as a whole can be cured even at low temperatures with the irradiation of high-energy radiation as a trigger, exhibiting excellent storage stability and ease of reaction control, thereby achieving superior handling properties.

Examples of high energy beams include UV rays, gamma rays, X-rays, alpha rays, electron beams, and the like. In particular, examples include ultraviolet rays, X-rays, and electron beams irradiated from a commercially available electron beam irradiating device. Of these, ultraviolet rays are preferable from the perspective of efficiency of catalyst activation, and ultraviolet rays within a wavelength range of 280 to 380 nm are preferable from the perspective of industrial use. Furthermore, the irradiation dose varies depending on the type of high energy beam activated catalyst, but in the case of ultraviolet light, the integrated irradiation dose at a wavelength of 365 nm is preferably within a range of 100 mJ/cm2 to 100 J/cm2.

Specific examples of component (c) include (methylcyclopentadienyl) trimethylplatinum (IV), (cyclopentadienyl) trimethylplatinum (IV), (1,2,3,4,5-pentamethylcyclopentadienyl)trimethylplatinum (IV), (cyclopentadienyl) dimethylethylplatinum (IV), (cyclopentadienyl) dimethylacetylplatinum (IV), (trimethylsilylcyclopentadienyl) trimethylplatinum (IV), (methoxycarbonylcyclopentadienyl) trimethylplatinum (IV), (dimethylphenylsilylcyclopentadienyl) trimethylcyclopentadienylplatinum (IV), trimethyl (acetylacetonate) platinum (IV), trimethyl (3,5-heptanedionate) platinum (IV), trimethyl (methylacetate) platinum (IV), bis (2,4-pentanedionate) platinum (II), bis (2,4-hexanedionate) platinum (II), bis (2,4-heptanedionate) platinum (II), bis (3,5-heptanedionate) platinum (II), bis (1-phenyl-1,3-butanedionate) platinum (II), bis (1,3-diphenyl-1,3-propanedionate) platinum (II), and bis (hexafluoroacetylacetonate) platinum (II), and among these, (methylcyclopentadienyl) trimethylplatinum (IV) and bis(2,4-pentanedionate) platinum (II) are preferred due to their versatility and ease of availability.

The amount of component (c) used is an effective amount and is not particularly limited so long as the amount promotes curing of the curable organopolysiloxane composition of the present invention. Specifically, the amount of metal atoms in the catalyst is 0.01 to 1,000 ppm by mass relative to the sum of components (a) to (c) (the total being 100 mass%), and preferably the amount of platinum metal atoms in component (c) is within a range of 0.1 to 500 ppm. This is because when the content of component (c) is less than the lower limit of a range, curing may be insufficient, whereas exceeding the upper limit of a range may be uneconomical and potentially adversely affect transparency, such as such as coloration of the obtained cured product.

[Component (d)]

The curable organopolysiloxane composition of the present invention may further contain (d) a reinforcing filler for the purpose of further improving the mechanical strength, especially hardness, of the organopolysiloxane cured product obtained using this composition, in addition to setting the value of $p_{x1}$ to a range. When the present composition is cured to obtain a cured product film for transducers, which is a dielectric layer, the reinforcing filler, component (d), preferably is at least partly made of inorganic oxide particles represented by silica, and preferably includes reinforcing filler which is component (d), or a composite thereof where one or more type are surface treated with an organic silica compound and have different average BET specific surface areas, in an amount that is within a certain range with regards to the sum of the non-volatile solid fraction formed by the curing reaction in the composition (that is, components (a) to (e)).

Herein, from the perspective of the mechanical strength of the cured product, the reinforcing microparticles are preferably one or more types of reinforcing inorganic microparticles having an average primary particle size of less than 50 nm. Examples include fumed silica, wet silica, pulverized silica, calcium carbonate, diatomaceous earth, finely pulverized quartz, various metal oxide powders other than alumina and zinc oxides, glass fibers, carbon fibers, and the like, and those treated with one or more types of organic silicon compounds described below are used. The shape thereof is not particularly limited, with arbitrary shapes including a particle shape, plate shape, needle shape, fibrous shape, and the like capable of being used.

Preferred examples thereof include: hydrophilic or hydrophobic fumed silica or metal oxide composites thereof, which have an average primary particle size that is 10 nm or less, are partially aggregated, and have BET specific surface areas that are mutually different as described later, from the perspective of improving the mechanical strength of the dielectric layer. Furthermore, in terms of improving dispersibility, the fumed silica or metal oxide composite thereof is preferably treated with silazane or a silane coupling agent described later. Two or more types of the reinforcing inorganic particles may be used in combination.

In the present invention, the reinforcing fillers used in the dielectric layer include:

(d1) reinforcing fine particles or a composite thereof surface treated by one or more organosilicon compounds having an average BET ratio surface area exceeding 100 $m^2/g$, and

(d2) reinforcing fine particles or a composite thereof having an average BET ratio surface area in a range of 10 to 100 $m^2/g$, wherein

the mass ratio of component (d1) to component (d2) may be in a range of 50:50 to 99:1, and may be in a range of 70:30 to 97:3, and is preferably within the range of 70:30 to 95:5. If the mass ratio is out of a range, the viscosity of the curable organopolysiloxane composition before curing may increase, and the mechanical strength and dielectric breakdown strength after curing may decrease.

When reinforcing filling materials, which are the aforementioned component (d1) and component (d2), are added into the composition, the dynamic strength and dielectric breakdown strength of the organopolysiloxane cured product obtained by curing the curable organopolysiloxane composition according to the present invention can be increased.

[Content of Component (d) ($w_f$)]

In the composition of the present invention, the content ($w_f$) of component (d) is preferably within a range of 5 to 40 mass%, particularly preferably within a range of 5 to 30 mass%, based on a total of components (a) to (e) being 100 mass%, which is the sum of the components forming the non-volatile solid fraction due to the curing reaction. Although deformability and moderate resilience are required for dielectric films in transducer applications, when the content of component (d) (wf) exceeds the upper limit, the viscosity of the composition will tend to increase, and the high viscosity may cause difficulty when applying uniformly as a thin film. Furthermore, the storage modulus after curing tends to increase and may be too hard, so performance in transducer applications may not be sufficiently realized. On the other hand, below the lower limit of the above mass% range, the physical properties of the curable organopolysiloxane composition after curing may be insufficient.

More preferably, the sum of component (d1) and component (d2) may be in a range of 5 to 40 mass%, preferably 5.0 to 35 mass%, and particularly preferably 6.5 to 30 mass%, when the total of components (a) to (e) is 100 mass%. If the upper limit of the above mass% range is exceeded, uniform and thin film application may be difficult, and the storage modulus after curing will be high. Below the lower limit of the mass% range, the physical properties of the curable organopolysiloxane composition after curing may be insufficient.

The reinforcing filling materials, which are component (d1) and component (d2) described above, are preferably surface treated with one or more type of organic silicon compounds. The surface treatment using the organic silicon compound is a hydrophobizing treatment, and a reinforcing filler surface-treated by the organic silicon compound may be uniformly dispersed in the fluoroorganopolysiloxane composition at a high filling ratio. Furthermore, an increase in the viscosity of the composition is inhibited, thereby improving moldability.

Examples of organic silicon compounds include: low molecular weight organic silicon compounds such as silanes, silazanes, siloxanes, and the like; and organic silicon polymers or oligomers such as polysiloxanes, polycarbosiloxanes, and the like. The organic silicon compound used for surface treatment most preferably contains at least one or more types selected from hexamethyldisilazane and 1,3-bis(3,3,3-trifluoropropyl)-1,1,3,3-tetramethyldisilazane.

The amount of the surface treating agent with regard to the total amount of the filler in the surface treatment is preferably within a range of 0.1 mass% or more and 50 mass% or less, and more preferably within a range of 0.3 mass% or more and 40 mass% or less. It should be noted that the treatment amount is preferably proportional to the added amount of fillers to the surface treating agent, with excess treating agent preferably removed after treatment. Furthermore, there is no problem in using additives and the like that promote or assist a reaction when treating as necessary.

In the surface treatment, whether or not the components of the surface treating agent are chemically or physically fixed to the surface of the filler is an important parameter. For example, the fixed amount of the surface treating agent can be analyzed by reacting a composition containing a filler with excess tetraethoxysilane under alkaline conditions, then detecting the reaction material via gas chromatography. The component amount of the surface treating agent fixed to the filler surface described above is preferably 1.0 part by mass or more, more preferably 3.0 parts by mass or more, relative to 100 parts by mass of the filler amount. Of these, when two types of organic silicon compounds used for the surface treatment of component (d1) and component (d2) according to the present invention are hexamethyldisilazane and 1,3-bis(3,3,3-trifluoropropyl)-1,1,3,3-tetramethyldisilazane, the ratio of fixation on each filler surface can be changed as needed. For example, in the present invention, as described above, the highly dielectric functional group may be a fluoroalkyl group represented by $(C_pF_{2p+1})$-R-(R (wherein R is an alkylene group having 1 to 10 carbon atoms, and p is an integer of 1 or more and 8 or less) introduced into part or all of component (a) or component (b1) and component (b2). From the perspective of dielectric properties, economy, ease of manufacturing, and moldability of the resulting curable organopolysiloxane composition, a group in which p = 1, that is, a trifluoropropyl group, may be used. In this case, the weight ratio of the treatment components derived from hexamethyldisilazane and 1,3-bis(3,3,3-trifluoropropyl)-1,1,3,3-tetramethyldisilazane fixed to the filler surface is between 0 and 10, inclusive. When outside a range, the affinity between component (a) or component (b) and the surface of the filler may deteriorate, leading to a risk of deterioration in workability and physical properties after curing.

[Other Functional Fillers]

In the curable fluoroorganopolysiloxane composition according to the present invention, other filling materials may or may not be used as desired, with examples including highly dielectric fillers, thermally conductive inorganic particles, insulating fillers, and the like. The inorganic microparticles may have two or more functions, such as a reinforcing filling material function or the like.

Examples of preferred dielectric inorganic fine particles include one or more inorganic fine particles selected from a group consisting of composite metal oxides in which a portion of barium and titanium sites of titanium oxide, barium titanate, strontium titanate, lead zirconate titanate, and barium titanate are substituted with calcium, strontium, yttrium, neodymium, samarium, dysprosium, or other alkaline earth metal, zirconium, or rare earth metals. Titanium oxide, barium titanate, zirconate titanate barium calcium, and strontium titanate are more preferable, with titanium oxide and barium titanate even more preferable. Specifically, at least a portion of the dielectric inorganic fine particles are particularly preferably dielectric inorganic fine particles with a specific dielectric constant at room temperature at 1 kHz of 10 or more. Note that the upper limit of the preferable size (average primary particle size) of the inorganic fine particles is 20,000 nm (20 $\mu$m), but more preferably 10,000 nm (10 $\mu$m), taking into consideration the workability into a thin film for transducers described later. By using the dielectric inorganic fine particles may further improve the mechanical properties and/or the electrical properties, particularly the dielectric constant, of the resulting organopolysiloxane cured product can be further improved in some cases.

Insulating inorganic fine particles that can be used in the present invention are not limited so long as the insulating inorganic materials are generally known, in other words, particles of inorganic materials having a volume resistivity of $10^{10}$ to $10^{18}$ $\Omega\cdot$cm, and the shape thereof can be any shape such as a particle shape, flake shape, or fiber shape (including whiskers). Specific examples thereof include ceramic spherical particles, plate shaped particles, and fibers. Preferably used examples thereof include metal silicates such as alumina, iron oxide, copper oxide, mica, talc, and the like, and particles such as quartz, amorphous silica, glass, and the like. Furthermore, these may be treated with various surface treating agents described later. These may be used independently or two or more may be used in combination. When the insulating inorganic fine particles are added to the composition, the dynamic strength and dielectric breakdown strength of the cured fluoroorganopolysiloxane product can be increased, with an increase in the specific dielectric constant also potentially being observed.

Examples of thermally conductive inorganic fine particles that can be used in the present invention include: metal oxide particles such as magnesium oxide, zinc oxide, nickel oxide, vanadium oxide, copper oxide, iron oxide, silver oxide, and the like; and inorganic compound particles such as aluminum nitride, boron nitride, silicon carbide, silicon nitride, boron carbide, titanium carbide, diamond, diamond-like carbon, and the like. Zinc oxide, boron nitride, silicon carbide, and silicon nitride are preferable. When one or more of the thermally conductive inorganic fine particles is added to the composition, the thermal conductivity of the organopolysiloxane cured product can be increased. The average particle size of the inorganic particles can be measured by a normal measurement method that is used in the field.

For example, when the average particle size is approximately 50 nm or larger and 500 nm or less, the particle size is measured by observation using a microscope such as a transmission type electron microscope (TEM), a field emission type transmission electron microscope (FE-TEM), a scanning type electron microscope (SEM), a field emission type scanning electron microscope (FE-SEM), or the like, allowing the average value to be obtained as a measure of the average primary particle size. Meanwhile, when the average particle size is approximately 500 nm or more, the value of the average primary particle size can be directly obtained using a laser diffraction/scattering type particle size distribution measuring device or the like.

The curable organopolysiloxane composition according to the present invention may optionally contain (e) an adhesion promoting agent. In particular, the composition in the present invention is cured to yield a cured product having a specific crosslink density and intermolecular crosslink structure, wherein the addition of an adhesion-imparting agent may form a chemical bond on the surface of the substrate layer or electrode layer to which the composition is applied, and may provide strong adhesion and tracking properties. This is particularly useful when designing the composition such that the electrode layer and dielectric layer have a chemically bonded structure.

The amount of (e) adhesion promoting agent used can be appropriately designed according to the desired adhesion strength, type of base material layer or electrode layer, or the like. However, from the perspective of achieving a practically sufficient level of adhesion strength and tracking to a base material layer or electrode layer made of thermoplastic resin such as polyethylene terephthalate (PET), the content of component (e) is preferably 0.1 mass% to 10 mass%, preferably 0.25 mass% to 5.0 mass%, and particularly preferably 0.5 mass% to 2.0 mass%, based on a total of components (a) to (e) constituting 100 mass% of the composition.

As the adhesion imparting agent, an organic silicon compound having at least one alkoxy group bonded to a silicon atom in one molecule is preferable. Examples of the alkoxy group include methoxy groups, ethoxy groups, propoxy groups, butoxy groups, and methoxyethoxy groups, with methoxy groups being particularly preferable. Furthermore, examples of groups bonded to a silicon atom other than the alkoxy groups in the organic silicon compound include: halogen-substituted or unsubstituted monovalent hydrocarbon groups such as alkyl groups, alkenyl groups, aryl groups, aralkyl groups, halogenated alkyl groups, and the like; glycidoxyalkyl groups such as 3-glycidoxypropyl groups, 4-glycidoxybutyl groups, and the like; epoxycyclohexylalkyl groups such as 2-(3,4-epoxycyclohexyl)ethyl groups, 3-(3,4-epoxycyclohexyl)propyl groups, and the like; epoxyalkyl groups such as 3,4-epoxybutyl groups, 7,8-epoxyoctyl groups, and the like; acrylic group-containing monovalent organic groups such as 3-methacryloxypropyl groups and the like; and hydrogen atoms.

This organic silicon compound preferably has a group that may react with an alkenyl group or a silicon atom-bonded hydrogen atom in the present composition, and specifically, preferably has a silicon atom-bonded hydrogen atom or an alkenyl group. Furthermore, favorable adhesion can be imparted to various base materials, and thus this organic silicon compound preferably has at least one epoxy group-containing monovalent organic group in one molecule. Examples of such an organic silicon compound include an organosilane compound, an organosiloxane oligomer, and an alkyl silicate. Examples of molecular structures of this organosiloxane oligomer or alkyl silicate include linear structures, partially branched linear structures, branched structures, cyclic structures, and network structures, of which linear structures, branched structures, and network structures are particularly preferable. Examples of the organic silicone compound include: silane compounds such as 3-glycidoxypropyltrimethoxysilane, 2-(3,4-epoxycyclohexyl) ethyltrimethoxysilane, and 3-methacryloxypropyltrimethoxysilane; siloxane compounds with at least one of each of a silicon atom-bonded alkenyl group or a silicon-bonded hydrogen atom and a silicon atom-bonded alkoxy group in one molecule; mixtures of a silane compound or siloxane compound having at least one silicon-bonded alkoxy group and a siloxane compound having at least one each of a silicon atom-bonded hydroxyl group and silicon atom-bonded alkenyl group in one molecule; reaction mixtures of an amino group-containing organoalkoxysilane and an epoxy group-containing organoalkoxysilane, an organic compound having at least two alkoxysilyl groups containing bonds other than silicon-oxygen bonds between the silyl groups in one molecule; epoxy-group-containing silanes or partial hydrolysis condensates thereof expressed by general formula: $R^a_n Si(OR^b)_{4-n}$
(wherein, $R^a$ represents an organic group containing a monovalent epoxy group, while $R^b$ represents an alkyl group having 1 to 6 carbon atoms, or a hydrogen atom; n represents a number within a range of 1 to 3), or a partially hydrolyzed condensate thereof; reaction mixtures of a vinyl group-containing siloxane oligomer (including those with chain or cyclic structures) and an epoxy group-containing trialkoxysilane; methyl polysilicates; ethyl polysilicates; and epoxy group-containing ethyl polysilicates. The adhesion imparting agent is preferably in the form of a low viscosity liquid, and the viscosity thereof is not limited, but is preferably within a range of 1 to 500 mPa·s at 25°C. In addition, while not limited thereto, the content of this adhesion imparting agent is preferably within a range of 0.01 to 10 parts by mass with regard to 100 parts by mass of the total of the present composition.

In the present invention, an example of a particularly preferable adhesion imparting agent is a reaction mixture of a vinyl group-containing siloxane oligomer (including those with a chain or cyclic structure) and an epoxy group-containing trialkoxysilane.

[Hydrosilylation Reaction Inhibitor]

A hydrosilylation reaction inhibitor is added to suppress crosslinking reactions and chain extending reactions from occurring between component (a) and component (b), thereby extending the pot life at room temperature and improving storage stability. Therefore, for practical purposes, a hydrosilylation reaction inhibitor that inhibits the curable composition of the present invention is a preferable component.

Examples of the hydrosilylation reaction inhibitor include acetylenic compounds, enyne compounds, organic nitrogen compounds, organic phosphorus compounds, and oxime compounds. Specific examples include: alkyne alcohols such as 3-methyl-1-butyn-3-ol, 3,5-dimethyl-1-hexyn-3-ol, 3-methyl-1-pentyn-3-ol, 1-ethynyl-1-cyclohexanol, phenyl butanol, and the like; enyne compounds such as 3-methyl-3-pentene-1-yne, 3,5-dimethyl-1-hexyn-3-yne, and the like; methylalkenylcyclosiloxanes such as 1,3,5,7-tetramethyl-1,3,5,7-tetravinylcyclotetrasiloxane, 1,3,5,7-tetramethyl-1,3,5,7-tetrahexenylcyclotetrasiloxane, and the like; as well as benzotriazoles.

The added amount of the hydrosilylation reaction inhibitor is an amount to effectively extend the working life at normal temperatures of the curable fluoroorganopolysiloxane composition for forming a film according to the present invention and improve the storage stability. Typically, it is within a range of 0.001 to 5 mass%, and preferably 0.01 to 2 mass%, per 100 mass% of component (a); however, this may be selected appropriately depending on the type of this component, the performance and content of the platinum-based catalyst, the amount of curable reactive groups (that is, alkenyl groups) in component (a), the amount of silicon-bonded hydrogen atoms in component (b), and the like.

[Use of Solvent]

While the curable organopolysiloxane composition of the present invention can be directly subjected to a curing reaction, an organic solvent can be used as required in order to improve the miscibility and handleability, when the composition or a portion thereof is in a solid state or a viscous liquid state. In particular, when the curable organopolysiloxane composition of the present invention is applied in the form of a film, the viscosity may be adjusted using a solvent so that the overall viscosity is in a range of 100 to 50,000 mPa·s. When diluting with a solvent, the amount of the solvent used may be in a range of 0 to 2,000 parts by mass relative to the sum (100 parts by mass) of the above components (a) to (c). In other words, in the composition of the present invention, the solvent may be 0 parts by mass and the composition is preferably a solvent-free type. In particular, by selecting a polymer with a low degree of polymerization for the curable organopolysiloxane composition of the present invention, a solvent-free design is possible, with no residue of a fluorinated solvent, organic solvent, or the like remaining in the film obtained after curing, which has the advantage of eliminating problems in terms of environmental impact and the effects of the solvent on electronic devices. Furthermore, a low-solvent type composition may be used and is preferably of an amount such that the amount of the solvent used is 10 parts by mass or less, and preferably 5 parts by mass or less, relative to the sum (100 mass parts) of the above components (a) to (c). Furthermore, in particular, the composition used in the electrode layer may be diluted with a solvent and applied in a thin film by spray application, as in the Embodiments described below.

Suitably, such an organic solvent is

one or more organic solvents selected from (f1) organic polar solvents,
(f2) small molecule siloxane solvents, and
(f3) halogen solvents, or a mixture thereof, having a boiling point of 80°C or more and less than 200°C is preferably used.

Note that the solvent may be a mixed solvent of different organic solvents of different or same type at an arbitrary ratio. Preferably, the organic solvents described contain at least one type of low molecular weight siloxane solvent selected from hexamethyldisiloxane, octamethyltrisiloxane, and mixtures thereof, which are commercially available from Dow Silicones Corporation under the names OS-10, O-20, and OS-2. Furthermore, when the fluoroalkyl group content in the curable elastomer composition is high, the optional use of these low molecular weight siloxane solvents together with the halogen solvents described above is also included in a preferable form of the present invention.

[Viscosity and Thixotropy of Composition]

The composition of the present invention can be applied to a base material layer or electrode layer, or the like and cured in film form for use, and in particular, when the overall viscosity and thixotropic properties are within a certain range, uniform application to the base material layer, or the like, and improved adhesion and tracking to the base material or electrode layer when cured can be achieved. In particular, compositions having a thixotropic index as defined below and containing an adhesion imparting agent are particularly preferred in that adhesion and chemical bonds at the interface are usually formed.

[Overall Viscosity]

The curable organopolysiloxane composition used in the present invention preferably has an overall viscosity in a range of 5 to 5,000 Pa·s, particularly preferably in a range of 100 to 2,000 Pa·s when measured at a shear rate using a viscoelasticity measuring device at 25°C (hereinafter simply referred to as "shear rate") of 0.1 $(S^{-1})$. In order to achieve the preferred viscosity range, although the amount of the organic solvent used can be adjusted, the composition can be a low-solvent type or solvent-free (solvent-free type).

[Thixotropic Index (TI)]

It is preferable that the curable organopolysiloxane composition of the present invention has excellent flowability and moderate thixotropic behavior. This makes it possible to achieve properties with low overall viscosity and excellent uniformity of application. Specifically, TI, which is a ratio of the viscosity $(\eta_{0.1})$ of the entire composition measured at a shear rate of 0.1 $(S^{-1})$ to the viscosity $(\eta_{10.0})$ of the entire composition measured at a shear rate of 10.0 $(S^{-1})$ $(=\eta_{0.1}/\eta_{10.0})$ of the composition is particularly preferably 250 or less. From the perspective of uniform application, the TI of this composition is especially preferably 100 or less, more preferably in a range of 10 to 80.

[Solid Content]

In the curable organopolysiloxane composition according to the present invention, the content of components that cure to form a non-volatile solid organopolysiloxane cured product (in the present invention, this may be simply referred to as the "solid content") is preferably in a range of 5 to 100 mass%, more preferably 50 to 100 mass%, 75 to 100 mass%, or 85 to 100 mass%, of the entire composition.

[Introduction of Dielectric Functional Groups]

When the organopolysiloxane cured product film according to the present invention is used as an electroactive film (for example, a dielectric film) used in a transducer such as a sensor, actuator, or the like, a high dielectric functional group may be introduced to the cured product. However, even an organopolysiloxane cured product film that does not contain a high dielectric functional group can be used as an electroactive film. Note that International Patent Application Publication WO 2014/105959 and the like by the present applicants propose, for example, introducing high dielectric functional groups and improving the specific dielectric constant.

The introduction of a highly dielectric functional group can be carried out by using a fluoroorganopolysiloxane or organohydrogenpolysiloxane having a highly dielectric functional group as part or all of the component (a) or component (b), or by adding an organic additive having a highly dielectric functional group, a non-reactive organosilicon compound having a highly dielectric functional group, or the like to the curable composition.

The type of the high dielectric functional group introduced to the organopolysiloxane cured product film is not particularly limited, and examples include: a) halogen atoms and groups containing a halogen atom as represented by 3,3,3-trifluoropropyl groups and the like; b) groups containing a nitrogen atom as represented by cyanopropyl groups and the like; c) groups containing an oxygen atom as represented by carbonyl groups and the like; d) heterocyclic groups such as imidazole groups and the like; e) groups containing a boron atom such as borate ester groups and the like; f) groups containing phosphorus such as phosphine groups and the like; and g) groups containing a sulfur atom such as thiol groups and the like. Halogen atoms including a fluorine atom and groups containing only a halogen atom are preferably used.

The curable organopolysiloxane composition of the present invention may be prepared by uniformly mixing a curable organopolysiloxane and a component promoting a curing reaction, preferably components (a) to (c), and by adding and uniformly mixing another optional component as necessary. Mixing at ambient temperature may be performed using various stirrers or kneaders. Mixing under heat may be performed when combining components that are not cured during mixing.

So long as curing does not occur during mixing, the adding order of the components is not particularly limited. When not used immediately after mixing, a crosslinking agent (for example, component (b)) and a curing reaction promoting component (for example, component (c)) may be stored separately in a plurality of containers so as to not be present in the same container, with the components in all containers capable of being mixed immediately prior to use.

The curing reaction of the curable organopolysiloxane composition of the present invention is normally achieved by heating this composition or exposing this composition to active energy rays. The curing reaction temperature by heating is not particularly limited, but is preferably 50°C or higher and 200°C or lower, more preferably 60°C or higher and 200°C or lower, and even more preferably 80°C or higher and 180°C or lower. Furthermore, the curing reaction can be performed in one or more steps, such as initial curing or semi-curing at a low temperature followed by full curing at a higher temperature, depending on the manufacturing process of the target laminate or transducer.

The time taken for the curing reaction depends on the structure of the above components (a), (b), (c) and (e) and the curing process described above, but is usually 1 second to 3 hours. Generally, the cured product or semi-cured product can be obtained by being maintained within a range of 90 to 180°C for 10 seconds to 120 minutes. Note that the film manufacturing method will be described later.

Examples of active energy rays that may be used in the curing reaction include ultraviolet rays, electron beams, radiation, and the like. Ultraviolet rays are preferable in terms of practicality. If the curing reaction is performed using ultraviolet rays, a catalyst for the hydrosilylation reaction having high activity to ultraviolet rays is used, for example, a bis(2,4-pentanedionato)platinum complex or a (methylcyclopentadienyl)trimethylplatinum complex is preferably added. The ultraviolet ray generating source is preferably a high pressure mercury lamp, a medium pressure mercury lamp, an Xe-Hg lamp, a deep UV lamp, or the like. The irradiation amount in this case is preferably 100 to 8,000 mJ/cm$^2$. For the purpose of shortening the curing time and continuing a sustained curing reaction at room temperature, the active energy ray irradiation and thermal curing reaction may be used in combination.

[Organopolysiloxane cured product]

The value of the storage modulus (G') at 23°C of the organopolysiloxane cured product obtained by curing the composition is preferably in a range of $5.00 \times 10^3$ to $1.00 \times 10^5$ Pa at the measurement frequencies of 0.1 Hz and 1 Hz, and the loss tangent at these measurement frequencies is less than 0.3. More preferably, the value of the storage modulus (G') at 23°C of the organopolysiloxane cured product obtained by curing the composition is preferably in a range of $1.00 \times 10^4$ to $7.50 \times 10^4$ Pa at the measurement frequencies of 0.1 Hz and 1 Hz, and the loss tangent at these measurement frequencies is 0.05 to 0.29. The loss tangent of the aforementioned organopolysiloxane cured product is generally larger at a measurement frequency of 1 Hz than at 0.1 Hz.

The composition of the present invention can be particularly suitable for use as a dielectric layer for transducers because curing yields an organopolysiloxane cured product having viscoelastic properties (especially storage modulus and loss tangent as mentioned above) in the above range, which can provide favorable reversion characteristic after deformation. Furthermore, the organopolysiloxane cured product of the present invention is preferably in the form of a film or sheet. In particular, the cured product film obtained by curing the composition of the present invention can be suitably used as a dielectric layer in transducers, and a organopolysiloxane cured product film form for transducers (hereinafter sometimes referred to as "cured product film for transducers") is particularly preferred.

[Laminate That Is a Transducer and Production Method Thereof]

The organopolysiloxane cured product of the present invention can be suitably used as a dielectric layer for transducers, and the film cured product for transducers, which is a dielectric layer, may have a structure with electrode layers on both sides (upper and lower layers) thereof, or may have a structure where both sides (upper and lower layers) are sandwiched by substrates, or may have a structure with an electrode layer on one side and a substrate layer on the other side, or where the substrate layer may be an intermediate layer.

More specifically, the transducer of the present invention preferably has a structure where one or more layer of organopolysiloxane cured product is interposed between at least one pair of electrode layers. The laminate that is the transducer may have electrode layers on both sides (upper and lower layers) of a dielectric layer made of the organopolysiloxane cured product, or may have structure with a substrate layer or intermediate layer between two or more dielectric layers with electrode layers on both sides (upper and lower layers) thereof, or a structure with two or more such laminate structures.

At the interface between the cured product film for transducers of the present invention and one or more layers selected from the electrode layer and the base material layer, the film is preferably at least partially bonded by chemical bonding, and when an attempt is made to peel off the laminate body, cohesive failure (CF) will preferably occur. In addition to the viscoelastic properties, the composition of the present invention exhibits favorable adhesion to many substrates.

Other layers constituting the laminate body of the present invention may be synthetic resin layers such as thermoplastic resins or the like, metal layers, or silicone cured layers containing conductive particulates, or the like, (which are electrode layers and are different from the cured product film for transducers of the present invention), and although not limited in particular, when at least some of the electrode layers and/or base material layers are thermoplastic resin layers (in the case of the electrode layers, thermoplastic resin layers containing conductive particles), the curable organopolysiloxane composition for transducers of the present invention is applied to at least a portion of these layers and cured to form at least partial chemical bonds at the interface of the two layers to form the laminate body. In particular, thermoplastic resin layers, such as PET layers, cannot achieve sufficient bonding/adhesion with ordinary silicone cured layers, which may cause delamination problems when used as a transducer component, however, the cured product film for transducers of the present invention has the advantage of significantly improved performance, reliability, and durability as a transducer component, from the perspective of being able to firmly adhere both members together and achieve a high degree of tracking.

The thermoplastic resin layer that can be used for the laminate body of the present invention is not particularly limited, but examples include thermoplastic resin film layers made of polyethylene terephthalate (PET), polyimide, polyethylene, polypropylene, polystyrene, polyvinyl chloride, polyvinylidene chloride, polycarbonate, cyclopolyolefin, nylon, and the like. When heat resistance is required in particular, a heat-resistant synthetic resin film such as a polyimide, polyetheretherketone, polyethylene naphthalate (PEN), liquid crystal polyacrylate, polyamide-imide, polyether sulfone, and the like is preferable. Conversely, in applications such as display devices in which visibility is required, a transparent base material, and specifically a transparent material such as a polypropylene, polystyrene, polyvinylidene chloride, polycarbonate, polyethylene terephthalate, PEN, and the like may be used. It should be noted that PET films are widely used in industry, and the film cured product for transducers of the present invention and PET films can be easily bonded.

The base material layer is preferably film-like or sheet-like. The thickness thereof is not particularly limited and can be designed with a desired thickness in accordance with the application. Furthermore, a primer, corona, etching, or plasma treatment may be used on the surface of the base material layer in advance to improve adhesion between the base material or the like and the cured product film for transducers, but with the present invention, chemical bonds can be easily formed between the two, so there is an advantage that an adhesive laminate body can be easily obtained without these pretreatments.

The method of obtaining such a laminate body is not particularly restricted, but it can be easily produced by a manufacturing method having a process of applying the curable organopolysiloxane composition for transducers of the present invention to at least one side of one or more layers selected from the electrode layer and the base material layer, and then curing.

Examples of methods of coating the curable organopolysiloxane composition into a film include, without limitation, gravure coating, offset gravure coating, offset gravure coating, roll coating using an offset transfer roll coater or the like, reverse roll coating, air knife coating, curtain coating using a curtain flow coater or the like, comma coating, Meyer bar, or other conventionally known methods used for the purpose of forming a cured layer. Furthermore, a plurality of layers of the curable organopolysiloxane composition of the present invention can be applied.

In the laminate body according to the present invention, the laminated organopolysiloxane cured product film preferably has a structure chemically bonded at an interface thereof. The structure is formed by bringing the organopolysiloxane cured product films after curing or before curing, or thin films of the curable organopolysiloxane composition in an uncured or semi-cured state, serving as precursors thereof (state before completely curing), into contact with each other, and then completely curing using heat or other means to advance a reaction between curing reactive groups at an interface between the cured product films. The process may be carried out by laminating in a layer-by-layer manner by advancing a curing reaction from the perspective of industrial production and production efficiency, or a plurality of curing reactive thin layers of the curable organopolysiloxane compositions may be pre-laminated and then completely cured as a whole using heat or other means.

More specifically, the laminate body of the present invention can be obtained by applying the curable organopolysiloxane composition for transducers to at least one side of one or more layers selected from the electrode layer and the base material layer, then stacking one or more layers selected from the other of the electrode layer or base material layer on the applied layer of the composition in an uncured or semi-cured state, and then fully curing the whole member. In addition, a laminate body having a film cured product for transducers between layers can be fabricated by fabricating a laminate body precursor having layers selected from two or three or more layers of electrode layers and base material layers laminated with a coating layer containing uncured curable organopolysiloxane composition for transducers between these layers (for example, a structure having but not limited to electrode layer / base material layer / (uncured composition layer) / base material layer / electrode layer, and the like), and curing the entire body.

The manufacturing method is particularly useful as a method for forming an electrode layer in a transducer member, and can industrially easily provide a laminate body, electronic component, or display device member, in which each layer, including the dielectric layer and electrode layer, are firmly joined and peeling or defect problems due to lack of adhesive strength and trackability is less likely to occur.

The laminate body of organopolysiloxane cured product films according to the present invention is useful as an electronic material, a member for a displaying device, and a member for transducers (including sensors, speakers, actuators, and generators), and can be particularly preferably used as an electroactive film (including high dielectric films) provided with an electrode layer, an electronic component or a member for a displaying device. Furthermore, as described above, an electroactive film with high dielectric breakdown strength is preferred in actuators and other transducer members in the form of a single layer or a laminated film and the present invention is particularly useful in applications such as sensors that require a pushing operation, speakers with high deformation frequency, or actuator and generators that operate under high voltage, because not only are the reversion characteristics favorable after deformation, but a structure where the layers are strongly bonded can be provided.

## INDUSTRIAL APPLICABILITY

The curable organopolysiloxane composition for transducers and the organopolysiloxane cured product thereof of the present invention are gels or elastomers having excellent return properties after deformation, and excellent electrical and mechanical properties, and can be designed to have high dielectric constant and mechanical strength (specifically, tensile strength, tear strength, elongation, and the like). Consequently, an electroactive silicone elastomer sheet or electroactive silicone gel sheet obtained by curing this organopolysiloxane composition into a thin film shape can be suitably utilized for an electroactive film (dielectric layer or electrode layer) configuring the transducer. For example, they are useful as transducer materials proposed by the present applicants in Patent Document 1 or 2, the present invention can also be applied, without particular restriction, to transducer devices using dielectric elastomers other than silicone, and designs can be made by replacing part or all of the dielectric elastomer layer with the above-mentioned cured product. A large number of structures of such a transducer (including the actuator) have been proposed, with examples thereof as International Patent Publications including WO 2011/118315, with examples thereof as Japanese Unexamined Patent Application Publications including JP 2008-533973 W, JP 2001-524278 W, JP 2008-187079 A, JP 2008-277729 A, JP 2009-59856 A, JP 2009-219302 A, JP 2012-65427 A, JP 2016-226258 A, JP 2017-064836 A, and the like. Note that the structural design or design changes associated with the substitution of a portion or all of the dielectric elastomer layer with the abovementioned cured product can be responded to via normal creation by those skilled in the art, with the present invention strongly suggesting such creation.

Similarly, the abovementioned cured product can be utilized in place of an electrolyte layer or dielectric layer in an actuator element structure known as a so-called "polymer actuator" or "polymer actuator." Specifically, a portion or all of an electrolyte layer can be substituted and utilized in a polymer actuator which has: the electrolyte layer (including an electrolyte layer in which an ionic liquid is contained in a polymer); and an electrode layer formed in the electrolyte layer, and which deforms in accordance with the voltage applied to the electrolyte layer. Note that a large number of structures of such a polymer actuator have been proposed, with examples thereof as International Patent Publications including WO 10/100907, WO 10/110417, WO 11/114965, WO 10/029992, WO 13/118628, and WO 14/104331, with examples thereof as Japanese Unexamined Patent Application Publications including JP 2004-282992 A, JP 2008-251697 A, JP 2010-003553 A, JP 2012-055153 A, JP 2013-255397 A, JP 2013-106491 A, JP 2013-251942 A, JP 2015-126597 A, JP 2015-186301 A, JP 2016-189651 A, and the like. Note that organopolysiloxane cured products according to the present invention can be designed in the desired shape in an elastomer or gel unlike electrolytes and are useful for structure designs particularly requiring lamination or a high displacement amount. Therefore, in the existing polymer actuator, structure designs or design changes which reflect the abovementioned mechanical properties and dielectric properties can be responded to via normal creation by those skilled in the art, with the present invention strongly suggesting such creation.

## EXAMPLES

The present invention will be described below by way of examples; however, the present invention is not limited thereto. The following compounds were used in the examples below.

- Component (a1): Dimethylsiloxane polymer (content of vinyl groups: 0.22 mass%, weight-average molecular weight (Mw): $3.99 \times 10^4$) blocked at both ends by a vinyldimethylsiloxy group.
- Component (a2): Dimethylsiloxane polymer (content of vinyl groups: 0.14 mass%, (Mw): $5.97 \times 10^4$) blocked at both ends by a vinyldimethylsiloxy group
- Component (a3x): Dimethylsiloxane polymer (content of vinyl groups: 0.09 mass%, (Mw): $9.95 \times 10^4$) blocked at both ends by a vinyldimethylsiloxy group.
  Note that (Mw) of component (a) is the polystyrene equivalent weight-average molecular weight measured by GPC (gel permeation chromatography) using toluene as the solvent.
- Component (b1): Dimethylsiloxy-methylhydrosiloxy-siloxane copolymer blocked at both ends with a trimethylsiloxy group (content of silicon-bonded water: 0.70 mass%)
- Component (b2): Dimethylsiloxane polymer blocked at both ends with a dimethyhydrosiloxy group (content of silicon-bonded water: 0.02 mass%)
- Component (c): Dimethyl siloxane polymer solution blocked at both ends by a vinyldimethylsiloxy group (approximately 0.6 weight% in platinum concentration) of a platinum-1,3-divinyl 1,1,3,3-tetramethyldisiloxane complex
- Component (d): Fumed silica treated with hexa methyldisilazane (product name prior to treatment: Aerosil 200)
- Component (e): Adhesion improving agent (= reaction product of methylvinylsiloxane and is glycidoxypropyl trimethoxysilane, blocked at both ends with a hydroxydimethylsiloxy group (content of vinyl groups (weight%) is in a range of 5.2 to 5.6))

<Hydrosilylation reaction inhibitor>

• Component (f): 1-ethynylcyclohexanol

[Examples 1 to 10, Comparative Examples 1 to 3]

Table 1 (Examples) and Table 2 (Comparative Examples) show the composition of each test example. The numerical value corresponding to each component is in mass%, and the sum thereof is 100 mass%. Furthermore, silicon atom-bonded hydrogen atoms (Si-H) of component (d) serving as a crosslinking agent per 1 mol of vinyl groups (unsaturated hydrocarbon group, same hereinafter) in the composition were used at an amount within a range of 0.54 to 0.76 moles, in the following examples. In this case, the $p_{x1}$ value and the $MW(a)/p_{x1}$ value in the composition were set as described in Tables 1 and 2. When mixing each component, the materials were prepared by final mixing under vacuum using a rotation/rotary mixer (product name: ARV-310LED, manufactured by Thinky Corporation).

[Viscosity of Composition Before Curing]

The viscosity prior to the curing of each composition was measured using a viscoelasticity measuring device (manufactured by Anton Paar, model number MCR302). Measurements were performed using a 20 mm diameter, 2° cone - plate with different shear rates. The overall viscosities of the compositions measured at 25°C and shear rates of 0.1 ($s^{-1}$) and 10.0 ($s^{-1}$) were recorded, respectively. Table 1 and Table 2 show the viscosity values, respectively.

[Preparation of cured product Sheet]

Each composition was interposed between Teflon (registered trademark) films that were approximately 150 $\mu$m thick, press-cured at 70°C for 60 minutes, and further post-cured in an oven at 130°C for 60 minutes to obtain cured sheets that were approximately 2 mm thick.

[Storage Modulus and Loss Modulus]

The viscoelasticity of each cured sheet obtained as described above was measured using a viscoelasticity measuring device (Anton Paar, model number MCR302). A Peltier element temperature control system and a 8 mm diameter parallel plate were used to set the sample to a thickness of approximately 2 mm. Measurements were made at 23°C with microdeformation (about 0.2%) and with frequency sweep. The storage modulus (G'), loss modulus (G") and loss tangent at 0.1 and 1.0 Hz are shown in Tables 1 and 2.

[Evaluation of Adhesion]

About 1 g of the curable organopolysiloxane composition was applied to a 200 μm thick polyethylene terephthalate film and cured at 130°C for 1 hour. The cured product was then pulled off with a spatula and visually evaluated to determine whether the peeling mode was interface peeling (AF) or cohesive breakdown (CF) based on the presence of cured product residue. The results are shown in Tables 1 and 2.

[Table 1]

| Example No. | 1 | 2 | 2 | 4 | 5 | 6 | 7 | 8 | 9 | 10 |
|---|---|---|---|---|---|---|---|---|---|---|
| Component (a1) | 79.23 | 79.88 | 80.53 | 83.24 | 84.06 | 79.79 | 83.13 | 83.35 | 83.48 | 22.08 |
| Component (a2) | | | | | | | | | | 61.70 |
| Component (a3x) | | | | | | | | | | |
| Component (d) | 9.50 | 9.50 | 9.50 | 9.50 | 9.50 | 9.50 | 9.50 | 9.50 | 9.50 | 7.91 |
| Component (e) | 1.00 | 1.00 | 1.00 | 1.00 | 1.00 | 1.00 | 1.00 | 1.00 | 1.00 | 1.00 |
| Component (f) | 0.10 | 0.10 | 0.10 | 0.10 | 0.10 | 0.10 | 0.10 | 0.10 | 0.10 | 0.10 |
| Component (b1) | 0.86 | 0.80 | 0.74 | 0.90 | 0.92 | 0.80 | 0.98 | 0.82 | 0.73 | 0.83 |
| Component (b2) | 8.50 | 7.90 | 7.31 | 4.45 | 3.60 | 8.00 | 4.48 | 4.42 | 4.37 | 5.58 |
| Component (f) | 0.80 | 0.80 | 0.80 | 0.80 | 0.80 | 0.80 | 0.80 | 0.80 | 0.80 | 0.80 |
| ([$H_{b1}$]+[$H_{b2}$])/[Total_Vi] | 0.70 | 0.65 | 0.60 | 0.65 | 0.65 | 0.65 | 0.70 | 0.60 | 0.54 | 0.74 |
| [$H_{b1}$] / [$H_{b2}$] | 4.69 | 4.69 | 4.69 | 9.35 | 11.83 | 4.63 | 10.10 | 8.60 | 7.78 | 6.86 |
| $p_{Xl}$ | 6.68 | 7.21 | 7.84 | 14.41 | 18.27 | 7.11 | 14.40 | 14.40 | 14.42 | 9.23 |
| (b) Weight% | 9.50 | 9.50 | 9.50 | 9.50 | 9.50 | 9.50 | 9.50 | 9.50 | 9.50 | 7.91 |
| Mw of component (a) in the composition (Mw(a)) | $3.99\times10^{4}$ | $3.99\times10^{4}$ | $3.99\times10^{4}$ | $3.99\times10^{4}$ | $3.99\times10^{4}$ | $3.99\times10^{4}$ | $3.99\times10^{4}$ | $3.99\times10^{4}$ | $3.99\times10^{4}$ | $5.97\times10^{4}$ |
| Mw(a)/$p_{Xl}$ | 5975 | 5531 | 5090 | 2769 | 2184 | 5614 | 2771 | 2770 | 2768 | 6467 |
| Viscosity 0.1 1/s (Pa·s) | 668 | 680 | 730 | 671 | 756 | 750 | 801 | 826 | 731 | 530 |
| Viscosity 10 1/s /s (Pa·s) | 18 | 19 | 20 | 19 | 21 | 20 | 22 | 23 | 21 | 28 |
| G' 0.1 Hz/ Pa | $3.32\times10^{4}$ | $2.67\times10^{4}$ | $2.06\times10^{4}$ | $3.37\times10^{4}$ | $3.46\times10^{4}$ | $2.29\times10^{4}$ | $4.75\times10^{4}$ | $1.97\times10^{4}$ | $1.18\times10^{4}$ | $4.89\times10^{4}$ |
| G" 0.1Hz/ Pa | $3.89\times10^{3}$ | $3.45\times10^{3}$ | $3.05\times10^{3}$ | $3.88\times10^{3}$ | $3.44\times10^{3}$ | $2.83\times10^{3}$ | $4.12\times10^{3}$ | $2.31\times10^{3}$ | $1.88\times10^{3}$ | $6.22\times10^{3}$ |
| Loss tangent 0.1 Hz | 0.12 | 0.13 | 0.15 | 0.11 | 0.10 | 0.12 | 0.09 | 0.12 | 0.16 | 0.13 |
| G' 1.0 Hz/ Pa | $4.02\times10^{4}$ | $3.28\times10^{4}$ | $2.58\times10^{4}$ | $4.03\times10^{4}$ | $4.07\times10^{4}$ | $2.80\times10^{4}$ | $5.51\times10^{4}$ | $2.38\times10^{4}$ | $1.51\times10^{4}$ | $6.14\times10^{4}$ |
| G" 1.0 Hz/ Pa | $7.96\times10^{3}$ | $7.01\times10^{3}$ | $6.00\times10^{3}$ | $7.13\times10^{3}$ | $6.59\times10^{3}$ | $6.10\times10^{3}$ | $8.14\times10^{3}$ | $4.72\times10^{3}$ | $3.85\times10^{3}$ | $1.38\times10^{3}$ |
| Loss tangent 1.0 Hz | 0.20 | 0.21 | 0.23 | 0.18 | 0.16 | 0.22 | 0.15 | 0.20 | 0.25 | 0.22 |

(continued)

| Example No. | 1 | 2 | 2 | 4 | 5 | 6 | 7 | 8 | 9 | 10 |
|---|---|---|---|---|---|---|---|---|---|---|
| Adhesion to PET | CF | CF | Substantially CF | CF | CF | CF | CF | CF | CF | CF |

[Table 2]

| Comparative Example No. | 1 | 2 | 3 |
|---|---|---|---|
| Component (a1) | 22.08 | 18.40 | 75.12 |
| Component (a2) | 59.50 | | |
| Component (a3x) | | 64.50 | |
| Component (d) | 7.91 | 6.59 | 9.50 |
| Component (e) | 1.00 | 1.00 | 1.00 |
| Component (f) | 0.10 | 0.10 | 0.10 |
| Component (b1) | 0.80 | 0.60 | 0.660 |
| Component (b2) | 7.80 | 8.40 | 12.81 |
| Component (c) | 0.80 | 0.40 | 0.80 |
| $([H_{b1}]+[H_{b2}])/[Total\_Vi]$ | 0.74 | 0.76 | 0.65 |
| $[H_{b1}] / [H_{b2}]$ | 4.69 | 3.27 | 2.39 |
| $p_{xl}$ | 6.32 | 4.29 | 3.67 |
| (b) Weight% | 7.91 | 6.59 | 9.50 |
| Mw of component (a) in the composition (Mw(a)) | $5.43\times10^4$ | $8.63\times10^4$ | $3.99\times10^4$ |
| Mw(a)/$p_{xl}$ | 18604 | 20121 | 10876 |
| Viscosity 0.1 1/s (Pa·s) | 646 | 339 | 690 |
| Viscosity 10 1/s /s (Pa·s) | 25 | 42 | 19 |
| G' 0.1 Hz/ Pa | $2.72\times10^4$ | $1.69\times10^4$ | $1.65\times10^4$ |
| G" 0.1Hz/ Pa | $5.36\times10^3$ | $5.76\times10^3$ | $2.90\times10^3$ |
| Loss tangent 0.1 Hz | 0.20 | 0.32 | 0.18 |
| G' 1.0 Hz/ Pa | $3.85\times10^4$ | $2.87\times10^4$ | $2.19\times10^4$ |
| G" 1.0 Hz/ Pa | $1.24\times10^4$ | $1.37\times10^4$ | $6.70\times10^3$ |
| Loss tangent 1.0 Hz | 0.32 | 0.43 | 0.31 |
| Adhesion to PET | CF | CF | CF |

[Summary]

As described above, in Examples 1 to 10, the weight-average molecular weight (Mw(a)) of component (a) and the value of Mw(a) divided by px1 of each component was set in the optimal range, whereby it was possible to keep the loss tangent below 0.3 while keeping G' of the composition after curing at $1.0\times10^4$ to $1.0\times10^5$ Pa at 23°C at frequencies of 0.1 and 1.0 Hz. Furthermore, the organopolysiloxane cured product according to the present invention has significantly superior mechanical properties, so the reversion characteristics after deformation due to external stress is suitable for various transducer applications, including sensors and actuators.

On the other hand, in Comparative Examples 1 to 3, when the weight-average molecular weight and the value of Mw(a) divided by $p_{x1}$ were not set within the prescribed ratio, the viscoelasticity as described above could not be obtained, and the film or sheet could not be sufficiently used as an electroactive film or electroactive sheet in various transducer applications, including actuators.

The cured products obtained using the curable organopolysiloxane compositions of the present invention examples have excellent adhesion to the substrate, and cured products thereof can be designed to be both flexible and tracking, and thus can be widely used.

**Claims**

1.   A curable organopolysiloxane composition for transducers, comprising

(a) a straight chain or branched chain organopolysiloxane or a mixture thereof, having a weight-average molecular weight Mw(a) of the entire component of less than $8.0 \times 10^4$ and having a curing reactive group containing at least two carbon-carbon double bonds in the molecule,

(b1) an organohydrogenpolysiloxane having at least one silicon-bonded hydrogen atom at a side chain site of the molecular chain, having no silicon-bonded hydrogen atoms at at least one terminus of the molecular chain, and having at least two silicon-bonded hydrogen atoms in the molecule, (b2) an organohydrogenpolysiloxane having a silicon-bonded hydrogen atom at both termini of the molecular chain and having at least two silicon-bonded hydrogen atoms in the molecule, and

(c) an effective amount of a hydrosilylation reaction catalyst, wherein

the molar quantity of silicon-bonded hydrogen atoms in component (b1) ($H_{b1}$),

the molar quantity of silicon-bonded hydrogen atoms in component (b2) ($H_{b2}$), and

the molar quantity of curable reactive groups containing carbon-carbon double bonds in component (a) (Vi) in the present composition are expressed by the following relationship:

$$p_{x1} = \{H_{b1}/H_{b2}\}/\{(H_{b1}+H_{b2})/Vi\}$$

the value obtained by dividing Mw(a) by the value of $p_{x1}$ defined as above is in a range of 1,000 to 8,000.

2. The curable organopolysiloxane composition for transducers according to claim 1, wherein the sum of the molar quantities of silicon-bonded hydrogen atoms of component (b1) and component (b2) is in a range of 0.1 to 0.99 mol per 1 mol of carbon-carbon double bonds in component (a).

3. The curable organopolysiloxane composition for transducers according to claim 1, wherein component (a) is a straight chain or branched chain organopolysiloxane or a mixture thereof, having a curing-reactive group containing a carbon-carbon double bond at both termini of the molecular chain.

4. The curable organopolysiloxane composition for transducers according to claim 1, further comprising (d) a reinforcing filler.

5. The curable organopolysiloxane composition for transducers according to claim 1, further comprising (e) an adhesion promoting agent.

6. The curable organopolysiloxane composition for transducers according to claim 1, wherein the overall viscosity of the composition is in a range of 100 to 2,000 Pa·s when measured at a shear rate of 0.1 ($s^{-1}$) using a viscoelasticity measurement device at 25°C.

7. The curable organopolysiloxane composition for transducers according to claim 1, wherein the value of the storage modulus (G') at 23°C of the organopolysiloxane cured product obtained by curing the composition is in a range of $5.00 \times 10^3$ to $1.00 \times 10^5$ Pa at measurement frequencies of 0.1 Hz and 1 Hz, and a loss tangent at these measurement frequencies is less than 0.3.

8. An organopolysiloxane cured product, comprising the cured or semi-cured curable organopolysiloxane composition for transducers according to any one of claims 1 to 7.

9. The organopolysiloxane cured product according to claim 8, in film or sheet form.

10. The organopolysiloxane cured product according to claim 8, used for at least one or more applications selected from transducer members, electronic materials, and display device members.

11. The organopolysiloxane cured product according to claim 8, being a dielectric layer for transducers.

12. A transducer, comprising a structure having at least one or more layers of the organopolysiloxane cured product according to claim 8 interposed between at least one pair of electrode layers.

13. A method of manufacturing a transducer, comprising at least a step of applying the curable organopolysiloxane composition for transducers according to any one of claims 1 to 7 in film or sheet form, and curing or semi-curing the composition.

## INTERNATIONAL SEARCH REPORT

| International application No. |
| --- |
| **PCT/JP2023/035780** |

**A. CLASSIFICATION OF SUBJECT MATTER**

***C08L 83/07***(2006.01)i; ***B32B 27/00***(2006.01)i; ***C08J 5/18***(2006.01)i; ***C08K 3/013***(2018.01)i; ***C08L 83/05***(2006.01)i; ***H04R 19/02***(2006.01)i; ***H10N 30/857***(2023.01)i

FI: C08L83/07; B32B27/00 101; C08J5/18 CFH; C08K3/013; C08L83/05; H04R19/02; H10N30/857

According to International Patent Classification (IPC) or to both national classification and IPC

**B. FIELDS SEARCHED**

Minimum documentation searched (classification system followed by classification symbols)

C08L83/00-83/16; C08K3/00-13/08; B32B1/00-43/00; C08J3/00-7/18; H10N30/00-30/88; H04R1/00-31/00; H02N1/00-2/18; H02N11/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2020/090797 A1 (DOW TORAY CO LTD) 07 May 2020 (2020-05-07)<br>claims, paragraphs [0205], [0263], column "examples" (for example, example 8), etc. | 1-13 |
| X | WO 2020/116596 A1 (DOW TORAY CO LTD) 11 June 2020 (2020-06-11)<br>claims, paragraph [0002], column "examples" (for example, composition example 3), etc. | 1-13 |
| X | WO 2020/121939 A1 (DOW TORAY CO LTD) 18 June 2020 (2020-06-18)<br>claims, paragraphs [0085], [0102], column "examples" (for example, example 5), etc. | 1-13 |
| X | WO 2021/125353 A1 (DOW TORAY CO LTD) 24 June 2021 (2021-06-24)<br>claims, column "examples" (for example, example 1), etc. | 1-13 |
| X | WO 2020/166692 A1 (DOW TORAY CO LTD) 20 August 2020 (2020-08-20)<br>claims, paragraph [0002], column "examples" (for example, example 2), etc. | 1-13 |
| X | WO 2020/116441 A1 (DOW TORAY CO LTD) 11 June 2020 (2020-06-11)<br>claims, column "examples" (for example, example 1), etc. | 1-13 |

| ✓ | Further documents are listed in the continuation of Box C. | ✓ | See patent family annex. |
| --- | --- | --- | --- |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **07 December 2023** | **19 December 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2023/035780**

### C. DOCUMENTS CONSIDERED TO BE RELEVANT

| Category* | Citation of document, with indication, where appropriate, of the relevant passages | Relevant to claim No. |
|-----------|-----------------------------------------------------------------------------------|-----------------------|
| X | WO 2020/017480 A1 (DOW TORAY CO LTD) 23 January 2020 (2020-01-23) claims, paragraph [0002], column "examples" (for example, example 2), etc. | 1-13 |
| P, X | WO 2023/282270 A1 (DOW TORAY CO LTD) 12 January 2023 (2023-01-12) claims, column "examples", etc. | 1-13 |

## INTERNATIONAL SEARCH REPORT
### Information on patent family members

International application No.

**PCT/JP2023/035780**

| Patent document cited in search report | | | Publication date (day/month/year) | Patent family member(s) | | | Publication date (day/month/year) |
|---|---|---|---|---|---|---|---|
| WO | 2020/090797 | A1 | 07 May 2020 | US | 2022/0340756 | A1 | |
| | | | | claims, paragraphs [0281], [0341], column "examples" (for example, example 8), etc. | | | |
| | | | | EP | 3875543 | A1 | |
| | | | | CN | 113166546 | A | |
| | | | | KR | 10-2021-0084572 | A | |
| WO | 2020/116596 | A1 | 11 June 2020 | US | 2022/0064448 | A1 | |
| | | | | claims, paragraph [0002], column "examples" (for example, composition example 3), etc. | | | |
| | | | | EP | 3892688 | A1 | |
| | | | | CN | 113348211 | A | |
| | | | | KR | 10-2021-0112322 | A | |
| | | | | TW | 202037675 | A | |
| WO | 2020/121939 | A1 | 18 June 2020 | CN | 113302255 | A | |
| | | | | KR | 10-2021-0102358 | A | |
| WO | 2021/125353 | A1 | 24 June 2021 | US | 2023/0015553 | A1 | |
| | | | | claims, column "examples" (for example, example 1), etc. | | | |
| | | | | EP | 4079811 | A1 | |
| | | | | KR | 10-2022-0119083 | A | |
| | | | | CN | 115038757 | A | |
| | | | | TW | 202132469 | A | |
| WO | 2020/166692 | A1 | 20 August 2020 | US | 2022/0089872 | A1 | |
| | | | | claims, paragraph [0002], column "examples" (for example, example 2), etc. | | | |
| | | | | EP | 3964299 | A1 | |
| | | | | KR | 10-2021-0132084 | A | |
| | | | | CN | 113631281 | A | |
| | | | | TW | 202104401 | A | |
| WO | 2020/116441 | A1 | 11 June 2020 | US | 2022/0089840 | A1 | |
| | | | | claims, column "examples" (for example, example no. 1), etc. | | | |
| | | | | EP | 3892687 | A1 | |
| | | | | KR | 10-2021-0101258 | A | |
| | | | | CN | 113330073 | A | |
| | | | | TW | 202037676 | A | |
| WO | 2020/017480 | A1 | 23 January 2020 | US | 2021/0238365 | A1 | |
| | | | | claims, paragraph [0002], column "examples" (for example, example 2), etc. | | | |
| | | | | EP | 3825352 | A1 | |
| | | | | KR | 10-2021-0032476 | A | |
| | | | | CN | 112673056 | A | |
| | | | | TW | 202012515 | A | |
| WO | 2023/282270 | A1 | 12 January 2023 | TW | 202313876 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014105959 A
- WO 2015098072 A
- WO 2020116440 A
- JP 2022026764 W
- WO 2011118315 A
- JP 2008533973 W
- JP 2001524278 W
- JP 2008187079 A
- JP 2008277729 A
- JP 2009059856 A
- JP 2009219302 A
- JP 2012065427 A
- JP 2016226258 A
- JP 2017064836 A
- WO 10100907 A

- WO 10110417 A
- WO 11114965 A
- WO 10029992 A
- WO 13118628 A
- WO 14104331 A
- JP 2004282992 A
- JP 2008251697 A
- JP 2010003553 A
- JP 2012055153 A
- JP 2013255397 A
- JP 2013106491 A
- JP 2013251942 A
- JP 2015126597 A
- JP 2015186301 A
- JP 2016189651 A